# EUROPÄISCHE PATENTANMELDUNG

(11) **EP 3 166 227 A1**
(43) Veröffentlichungstag der Anmeldung: **10.05.2017**
(21) Anmeldenummer: 16196176.8
(22) Anmeldetag: 28.10.2016
(51) Int. Cl.: H03K 17/78, H03K 17/10

(54) **AUTARKES STEUERMODUL ZUM MODULIEREN EINER HOCHSPANNUNG**

(30) Priorität: 28.10.2015 DE 102015013932
(71) Anmelder: Helmut-Schmidt-Universität/ Universität der Bundeswehr Hamburg, 22043 Hamburg (DE); Hamburg Innovation GmbH, 21079 Hamburg (DE)
(72) Erfinder: Kemper, Johannes, 21465 Reinbek (DE); Hoffmann, Klaus F., 22523 Hamburg (DE)
(74) Vertreter: Maiwald Patentanwalts GmbH

(57) **Zusammenfassung**

Steuermodul (1) zum Modulieren einer Hochspannung U₀, umfassend einen Eingang (2) für ein Steuersignal (3) sowie mindestens ein Steuerelement (4), das im durch die Hochspannung U₀ getriebenen Stromkreis (A-B) einen Widerstand bildet, dessen Betrag als Funktion einer Stellgröße (5) veränderlich ist, weiterhin umfassend eine Treiberschaltung (6) zur Bildung der Stellgröße (5) aus dem eingangsseitigen Steuersignal (3), wobei innerhalb des Steuermoduls (1) eine Rückkopplung (7, 7a-7h) der über dem Steuerelement (4) abfallenden Spannung U₁ vorgesehen ist, die die Stellgröße (5) in Abhängigkeit dieser Spannung U₁ ändert und wobei die Treiberschaltung mindestens eine stromgesteuerte Verstärkerstufe (19, 20, 21) für die Rückkopplung (7, 7a-7h) umfasst, und/oder wobei die Treiberschaltung (6) ihre Versorgungsspannung Vcc aus der über dem Steuerelement (4) abfallenden Spannung U₁ bezieht (8a, 8b) und der der Eingang (2) für das Steuersignal (3) ein optischer Eingang, der über eine direkte Sichtverbindung, und/oder über mindestens einen spekularen oder diffusen Reflektor (33), von einem zentralen Sender (30) beleuchtbar ist, oder ein Funkempfänger ist.

## Beschreibung

Die Erfindung betrifft Steuermodule für Hochspannung, insbesondere für Anwendungen, in denen häufige Schaltvorgänge erforderlich sind.

### Stand der Technik

Im Bereich der Energietechnik werden elektrische Hochspannungen in bestimmten Bereichen mit mechanischen Schaltern geschaltet. Diese Schalter umfassen Kontakte, die zum Einschalten aufeinander zu bewegt und zum Ausschalten voneinander weg bewegt werden. Bedingt durch Lichtbögen unterliegen die Kontakte einem Verschleiß. Daher ist ein derartiger Schalter nur für eine begrenzte Anzahl von Schalthandlungen verwendbar. Bedingt durch die mechanische Bewegung von Bauteilen und die hierbei maximal mögliche Beschleunigung ist auch die Geschwindigkeit des Schaltens deutlich limitiert.

Für Anwendungen, in denen häufigere Schalthandlungen in schneller Folge gewünscht sind, werden daher elektronische Schalter verwendet. Diese enthalten insbesondere Halbleiterbauelemente als Steuerelemente. Da die maximale Blockierspannung eines solchen Steuerelements häufig nicht für die zu schaltende Hochspannung ausreicht und Steuerelemente mit zunehmender maximaler Blockierspannung überproportional weniger verfügbar und teurer sind, ist in einem elektronischen Hochspannungsschalter je nach Anwendungsgebiet eine Vielzahl von Steuermodulen in Reihe geschaltet, die jeweils mindestens ein leistungselektronisches Halbleiterbauelement als Steuerelement enthalten.

Nachteilig ist die aufwändige Schaltungstechnik für derartige Schalter. Jedes Steuermodul enthält eine Treiberschaltung zur Ansteuerung des im Steuermodul enthaltenen Steuerelements mit einer Stellgröße. All diese Treiberschaltungen müssen zum Einen mit elektrischer Energie und zum Anderen mit entsprechenden Steuersignalen zum Ein- und Ausschalten versorgt werden. Die Energieversorgung wird dadurch sehr anspruchsvoll, dass sich jedes Steuermodul auf einem anderen Potential befindet. Die Versorgungsspannung muss also für jedes Steuermodul über eine Potentialbarriere mit einer individuellen Höhe angehoben werden.

Weiterhin unterliegen sowohl die Schalteigenschaften der Steuerelemente als auch die Eigenschaften der Treiberschaltungen in den Steuermodulen fertigungsbedingt einer gewissen Montage- und Bauteilstreuung. Dies kann dazu führen, dass in einer Reihenschaltung aus einer Vielzahl von Steuermodulen auch bei gleichzeitiger Ansteuerung aller Steuermodule nicht alle in diesen Steuermodulen enthaltenen Steuerelemente gleichzeitig schalten. Dadurch können prinzipiell Betriebszustände auftreten, in denen über einem einzelnen Steuerelement eine höhere Spannung als dessen maximal zulässige Blockierspannung abfällt. Solche Betriebszustände können zur Zerstörung des Steuerelements und zum Versagen des ganzen Schalters führen und sind daher unbedingt zu vermeiden. Hierfür ist ein erheblicher zusätzlicher Aufwand erforderlich.

### Aufgabe und Lösung

Es ist eine Aufgabe der Erfindung, ein Steuermodul zur Verfügung zu stellen, das mit geringerem schaltungstechnischem Aufwand in einem Hochspannungsschalter aus vielen derartigen Steuermodulen integrierbar ist. Es ist eine weitere Aufgabe der Erfindung, eine Steuerschaltung zum Modulieren einer Hochspannung zur Verfügung zu stellen, die mit geringerem schaltungstechnischem Aufwand realisierbar ist.

Diese Aufgaben werden erfindungsgemäß gelöst durch ein Steuermodul gemäß Hauptanspruch und durch eine Steuerschaltung gemäß Nebenanspruch. Weitere vorteilhafte Ausgestaltungen ergeben sich aus den darauf rückbezogenen Unteransprüchen.

### Gegenstand der Erfindung

Im Rahmen der Erfindung wurde ein Steuermodul zum Modulieren einer Hochspannung U₀ entwickelt. Dabei umfasst der Begriff des Modulierens neben dem Ein- und Ausschalten auch jede andere Änderung der Amplitude, und bei ein- oder mehrphasigen Wechselspannungen auch der Phase, der Hochspannung U₀; dabei wird die Änderung von einem Steuersignal getrieben. Beispielsweise kann auch ein analoges oder digitales Signal auf eine Hochspannung U₀ aufinoduliert werden, so dass dieses Signal in dem durch die Hochspannung U₀ getriebenen Stromkreis transportiert werden kann.

Das Steuermodul weist einen Eingang für ein Steuersignal sowie mindestens ein Steuerelement auf. Dieses Steuerelement bildet im durch die Hochspannung U₀ getriebenen Stromkreis einen Widerstand, dessen Betrag als Funktion einer Stellgröße veränderlich ist. Der Widerstand kann abhängig von der Stellgröße insbesondere so kleine Werte annehmen, dass er in dem Stromkreis als Durchgang anzusehen ist. Der Widerstand kann abhängig von der Stellgröße aber auch insbesondere so große Werte annehmen, dass er in dem Stromkreis als Unterbrechung anzusehen ist. Das Steuerelement umfasst vorteilhaft ein Halbleiterbauelement, welches vorteilhaft insbesondere ein Transistor, ein Thyristor, ein MOSFET oder ein IGBT sein kann. Die Stellgröße kann bei einem Transistor, einem MOSFET oder einem IGBT als Steuerelement beispielsweise eine an einer Steuerelektrode (Gate) vorgelegte Spannung sein. Bei einem Thyristor kann die Stellgröße beispielsweise ein Strom-Zündimpuls zum Einschalten sein. Transistoren, MOSFETs und IGBTs können in einem analogen Bereich, insbesondere in einem linearen Bereich, betrieben werden, während Thyristoren lediglich eingeschaltet werden können.

Das Steuermodul weist weiterhin eine Treiberschaltung auf, die aus dem eingangsseitigen Steuersignal die Stellgröße für das Steuerelement bildet.

In einer ersten vorteilhaften Ausgestaltung der Erfindung ist innerhalb des Steuermoduls eine Rückkopplung der über dem Steuerelement abfallenden Spannung U₁ vorgesehen, die die Stellgröße in Abhängigkeit dieser Spannung U₁ ändert. Dabei umfasst die Treiberschaltung in einer besonders vorteilhaften Ausgestaltung der Erfindung mindestens eine stromgesteuerte Verstärkerstufe für die Rückkopplung. Unter einer Rückkopplung ist allgemein zu verstehen, dass die über dem Steuerelement abfallende Spannung U₁ oder eine hieraus abgeleitete Größe in die Bildung der Stellgröße eingeht oder dass in Abhängigkeit dieser Spannung U₁ Vorgänge ausgelöst werden, die ihrerseits die am Steuerelement vorgelegte Stellgröße beeinflussen.

Alternativ oder insbesondere auch in Kombination hierzu bezieht das Steuermodul seine Versorgungsspannung Vcc aus der über dem Steuerelement abfallenden Spannung U₁. Dann können insbesondere die Treiberschaltung, und/oder alle für die Berücksichtigung der Rückkopplung erforderlichen Schaltungskomponenten, aus dieser Versorgungsspannung Vcc gespeist werden. Dabei ist in einer besonders vorteilhaften Ausgestaltung der Erfindung der Eingang für das Steuersignal ein optischer Eingang, der über eine direkte Sichtverbindung, und/oder über mindestens einen spekularen oder diffusen Reflektor, von einem zentralen Sender beleuchtbar ist.

Beiden Maßnahmen liegt die gemeinsame Idee zu Grunde, dass die Treiberschaltung nicht mehr nur einpolig mit dem Potential des durch die Hochspannung U₀ getriebenen Stromkreises auf einer Seite des Steuerelements verbunden ist zwecks Herstellung eines Bezugspunktes für das Potential in dieser Treiberschaltung. Stattdessen ist die Treiberschaltung, zumindest aber ihre Spannungsversorgung, mit den Potentialen in diesem Stromkreis zu beiden Seiten des Steuerelements verbunden. Dies hat die doppelte Wirkung, dass die Differenz zwischen beiden Potentialen, also die über dem Steuerelement abfallende Spannung U₁, zum Einen erstmals durch das Steuermodul selbst überwacht und zum Anderen als Energiequelle für das Steuermodul genutzt werden kann. Die Erfindung bezieht sich also ganz allgemein auf ein Steuermodul zum Modulieren einer Hochspannung U₀, umfassend einen Eingang für ein Steuersignal sowie mindestens ein Steuerelement, das im durch die Hochspannung U₀ getriebenen Stromkreis einen Widerstand bildet, dessen Betrag als Funktion einer Stellgröße veränderlich ist, weiterhin umfassend eine Treiberschaltung zur Bildung der Stellgröße aus dem eingangsseitigen Steuersignal, wobei die über dem Steuerelement abfallende Spannung U₁ in die Treiberschaltung geführt ist und/oder die Treiberschaltung mit elektrischer Energie speist. Bei den meisten herkömmlichen Steuermodulen lag hingegen die über dem Steuerelement abfallende Spannung U₁ ausschließlich über diesem Steuerelement an. Sowohl die Treiberschaltung als auch ihre Spannungsversorgung waren von dieser hohen Spannung U₁ strikt getrennt; in diesen Bereichen war jeweils die Versorgungsspannung Vcc für die Treiberschaltung die höchste auftretende Potentialdifferenz.

Es wurde erkannt, dass die Rückkopplung die Betriebssicherheit des Steuermoduls wesentlich verbessert. Das in dem Steuermodul enthaltene Steuerelement befindet sich in dem durch die Hochspannung U₀ getriebenen Stromkreis in vielen Anwendungen in einer Reihenschaltung mit anderen Bauelementen und bildet insofern einen Teil eines Spannungsteilers, über dem in der Summe die gesamte Hochspannung U₀ abfällt. Dabei können die Widerstände dieser anderen Bauelemente ebenfalls veränderlich sein. Es können dann Betriebszustände eintreten, in denen in der Reihenschaltung über dem Steuerelement eine Spannung U₁ abfällt, die die für dieses Steuerelement maximal zulässige Blockierspannung übersteigt. Das Steuerelement kann dann spontan durchbrechen und zerstört werden.

Derartige Betriebszustände können beispielsweise in einer Steuerschaltung auftreten, in denen eine Reihenschaltung aus mindestens zwei Steuermodulen, bevorzugt aus zwischen 50 und 100 Steuermodulen und ganz besonders bevorzugt aus zwischen 70 und 90 Steuermodulen, in den durch die Hochspannung U₀ getriebenen Stromkreis geschaltet ist. Solche Steuerschaltungen sind, wie auch jedes einzelne Steuermodul, insbesondere als schnelle, verschleiß freie Schalter für die Hochspannung U₀ verwendbar. Der Preis von Steuerelementen nimmt mit zunehmender maximaler Blockierspannung deutlich überproportional zu, während gleichzeitig die Verfügbarkeit solcher Steuerelemente am Markt abnimmt. Oberhalb einer maximalen Blockierspannung von etwa 1.200 V werden Steuerelemente häufig nur von einigen wenigen Herstellern oder gar nur von einem einzigen Hersteller angeboten. Ein solches Steuerelement durch eine Reihenschaltung von Steuerelementen mit jeweils deutlich geringerer Spannungsfestigkeit zu ersetzen, vereinfacht und verbilligt die Herstellung der Steuerschaltung enorm, da die weniger spannungsfesten Steuerelemente von vielen Herstellern in großen Stückzahlen verkauft werden. Diese Vereinfachung und Verbilligung ist jedoch nur im Tausch gegen die harte Randbedingung zu haben, dass die über jedem einzelnen Steuerelement abfallende Spannung U₁ zu keinem Zeitpunkt dessen maximale Blockierspannung überschreitet.

Mit der erfindungsgemäß vorgesehenen Rückkopplung steht nun ein Instrument zur Verfügung, das die Einhaltung dieser Randbedingung sicher gewährleisten kann. Dazu kann die Rückkopplung insbesondere dazu ausgebildet sein, die über dem Steuerelement abfallende Spannung U₁ unter einem Grenzwert zu halten, und/oder von einem Wert oberhalb dieses Grenzwerts auf oder unter diesen Grenzwert zurückzuführen. Steigt die über dem Steuerelement abfallende Spannung U₁ zu stark an, bewirkt die Änderung der Stellgröße durch die Rückkopplung, dass der Widerstand des Steuerelements vermindert wird. Dadurch verringert sich unmittelbar die über dem Steuerelement abfallende Spannung U₁.

Dabei sorgt die mindestens eine stromgesteuerte Verstärkerstufe zum Einen dafür, dass die Treiberschaltung besonders energiesparend arbeitet. Dies ist besonders vorteilhaft, wenn die Treiberschaltung ihre Versorgungsspannung Vcc aus der über dem Steuerelement abfallenden Spannung U₁ bezieht. Die Spannung U₁ kann je nach Schaltzustand des Steuerelements sehr stark schwanken. Blockiert das Steuerelement vollständig, kann über ihm eine Spannung der Größenordnung 1000 V abfallen; ist es hingegen vollständig durchgeschaltet, fällt über ihm nur eine sehr geringe Spannung von einigen Volt ab. Die Erfindung stellt eine Spannungsversorgung bereit, die aus einem sehr großen Eingangsspannungsbereich, beispielsweise 100 V bis 1000 V, eine gleichbleibende Versorgungsspannung Vcc erzeugen kann. Der große Eingangsspannungsbereich wird auf Kosten des Wirkungsgrades realisiert. Der geringe Energieverbrauch der Treiberschaltung sorgt dafür, dass dies per saldo kein Nachteil ist.

Zum Anderen ist eine stromgesteuerte Verstärkerstufe vergleichsweise unempfindlich gegenüber Störungen, die meistens in Form von Spannungen eingekoppelt werden. Die elektromagnetische Verträglichkeit der Treiberschaltung ist also vorteilhaft verbessert.

Ist beispielsweise ein Schalter als Reihenschaltung aus mehreren Steuermodulen realisiert und wird versucht, den Schalter zu schließen (= einzuschalten), kann der Fall eintreten, dass einige Steuermodule schneller auf Durchgang schalten als die restlichen. Die über dem Schalter insgesamt abfallende Spannung U₀ verteilt sich dann nur noch auf diejenigen Steuermodule, die noch im nicht durchgängigen Zustand (= ausgeschaltet) sind sowie bei einem auftretenden Stromfluss anteilmäßig auf den resultierenden Kreisinnenwiderstand des Hochspannungskreises, so dass die ausgeschalteten Steuerelemente in diesen Steuermodulen mit einer deutlich höheren Spannung U₁ belastet werden. Die erfindungsgemäße Rückkopplung sorgt dafür, dass diese Steuerelemente automatisch zumindest in einem Maße durchgängig geschaltet werden, dass sie nicht zerstört werden, was wiederum mit einem entsprechenden Stromfluss verbunden ist

Umgekehrt kann beim Öffnen (= Ausschalten) des Schalters der Fall eintreten, dass einige Steuermodule den übrigen vorauseilen, so dass die gesamte über dem Schalter abfallende Spannung U₀ sich nur auf die Steuerelemente in den vorauseilenden Steuermodulen verteilt respektive bei einem auftretenden Stromfluss anteilmäßig auf den Kreisinnenwiderstand des Hochspannungskreises. In diesem Fall sorgt die erfindungsgemäße Rückkopplung dafür, dass die vorauseilenden Steuermodule wieder entsprechend durchgängig geschaltet werden. Das Öffnen des Schalters wird also effektiv abgebrochen.

Nach dem bisherigen Stand der Technik gab es nur zwei Möglichkeiten, zu verhindern, dass eine unzulässig hohe Spannung U₁ über dem Steuerelement des Steuermoduls abfällt.

Die erste Möglichkeit bestand darin, ein Beschaltungsnetzwerk aus Widerständen, Kondensatoren sowie optional auch Dioden und weiteren Halbleiterbauelementen parallel zum Steuerelement zu schalten. Dieses im Englischen als "snubber" bezeichnete Beschaltungsnetzwerk war so dimensioniert, dass es bezüglich parasitärer Eigenschaften, die für die über der Parallelschaltung abfallende Spannung U₁ maßgeblich waren, dominierend war. Der Grundgedanke war, dass insbesondere Widerstände, Kondensatoren und Induktivitäten als rein passive Bauelemente in ihren Eigenschaften deutlich weniger stark streuen als Steuerelemente, insbesondere Halbleiterbauelemente. Hatten in einer Reihenschaltung einer Vielzahl von Steuermodulen die Steuerelemente beispielsweise leicht unterschiedliche Leckströme, so wurde dies durch die Parallelschaltung mit einem passiven Beschaltungsnetzwerk, dessen Leckstrom beispielsweise um eine Größenordnung höher war, gleichsam maskiert. Ähnlich wurde verfahren, um etwa Unterschiede in den parasitären Kapazitäten der Steuerelemente zu maskieren.

Der wesentliche Nachteil einer Parallelschaltung des Steuerelements mit einem Beschaltungsnetzwerk ist, dass dieses Beschaltungsnetzwerk ständig Teil des durch die Hochspannung getriebenen Stromkreises ist. Ist das Steuermodul beispielsweise als Hochspannungsschalter ausgebildet und befindet es sich im geöffneten (= ausgeschalteten) Zustand, in dem es einen Stromfluss eigentlich blockieren sollte, so ist das Beschaltungsnetzwerk für den Ruhestrombedarf, und damit für die Verlustleistung, des Steuermoduls maßgeblich. Dadurch wird unnötige Wärme produziert und der Gesamtwirkungsgrad des Systems verschlechtert.

Weiterhin ist insbesondere ein Beschaltungsnetzwerk, das Dioden oder weitere Halbleiterbauelemente enthält, sehr aufwändig, da es nach dem zuvor Gesagten darauf ankommt, dass die Eigenschaften der eingesetzten Bauelemente nicht zu stark streuen. Es rentiert sich in der Regel nur bei höheren und höchsten Leistungen oder besonders harten Anforderungen, ein Beschaltungsnetzwerk mit Dioden oder anderen Halbleiterbauelementen zu realisieren.

Die erfindungsgemäße Rückkopplung ersetzt das Beschaltungsnetzwerk und überwindet die damit verbundenen Nachteile.

Die zweite Möglichkeit war, die über dem Steuerelement abfallende Spannung U₁ durch eine externe Instanz zu überwachen und auf eine zu hohe Spannung U₁ mit einer Änderung des dem Steuermodul zugeführten Steuersignals zu reagieren. So wurde beispielsweise in einer als Hochspannungsschalter dienenden Reihenschaltung von Steuermodulen die über jedem einzelnen Steuerelement abfallende Spannung U₁ zentral gemessen. Stellte sich bei dieser Messung beispielsweise heraus, dass bei gleichzeitiger Ansteuerung aller Steuermodule ein Steuerelement in einem dieser Steuermodule verfrüht oder verspätet schaltet, wurde das Timing des Steuersignals für das betreffende Steuermodul entsprechend angepasst. Da die Einrichtung für diese Art der Koordination mit allen in der Reihenschaltung vorkommenden Potentialen arbeiten musste, war der schaltungstechnische Aufwand beträchtlich. Die erfindungsgemäße Rückkopplung findet innerhalb eines einzelnen Steuermoduls statt und arbeitet nur mit den Potentialen, zwischen die dieses eine Steuermodul geschaltet ist. In einer Reihenschaltung ist jedes einzelne Steuermodul autark; es muss keine Infrastruktur für eine Kommunikation zwischen verschiedenen Steuermodulen, oder für eine Rückmeldung der einzelnen Steuermodule an eine Zentrale, aufgebaut werden.

Besonders vorteilhaft ist das Steuerelement dazu ausgebildet, bei einer betragsmäßigen Erhöhung der Stellgröße seinen Widerstand zu vermindern, also durchgängiger zu werden. Es kann dann besonders einfach eine ODER-Verknüpfung dergestalt realisiert werden, dass das Steuerelement dann durchgängig ist, wenn ein diesbezügliches Steuersignal anliegt, jedenfalls aber dann, wenn es zur Verminderung der über dem Steuerelement abfallenden Spannung U₁ zwingend notwendig ist.

In einer vorteilhaften Ausgestaltung der Erfindung ist die Rückkopplung innerhalb der Treiberschaltung einem Signal, aus dem die Stellgröße gebildet wird, überlagert. Dies erfordert nur eine zusätzliche additive Einspeisung der Rückkopplung an einem Punkt in der ansonsten unveränderten Treiberschaltung.

Wenn die Treiberschaltung ausgangsseitig eine Spannung als Stellgröße liefert, hängt es vom Widerstand zwischen diesem Ausgang und Masse ab, wieviel Strom zum Erhöhen dieser Stellgröße auf einen neuen Sollwert durch die Rückkopplung und zum Halten dieses neuen Sollwerts erforderlich ist. Dieser Strombedarf kann in einer besonders vorteilhaften Ausgestaltung der Erfindung vermindert werden, indem die Rückkopplung dazu ausgebildet ist, den Ausgang der Treiberschaltung gegen Masse hochohmig zu schalten. Insbesondere wenn das Steuerelement ein Halbleiterbauelement ist, dessen Widerstand durch die Beaufschlagung einer Steuerelektrode (Gate) mit einer Ladung gesteuert wird, kann diese Ladung nach dem Verbringen auf die Steuerelektrode dort durch den hochohmigen Widerstand gegen Masse gehalten werden.

In einer weiteren vorteilhaften Ausgestaltung der Erfindung ist die Rückkopplung am Eingang der Treiberschaltung dem Steuersignal überlagert, und/oder die Rückkopplung unterdrückt dieses Steuersignal. Unter einer Unterdrückung ist zu verstehen, dass die Rückkopplung die Treiberschaltung daran hindert, auf Änderungen des Steuersignals zu reagieren. Die direkte Einflussnahme auf das Steuersignal, bzw. auf seine weitere Verarbeitung, hat zur Folge, dass die Rückkopplung mit dem kompletten Verstärkungsfaktor durchgreift, mit dem auch das Steuersignal von der Treiberschaltung verarbeitet wird.

In einer weiteren vorteilhaften Ausgestaltung der Erfindung ändert die Rückkopplung die Stellgröße nur dann, wenn die über dem Steuerelement abfallende Spannung U₁ einen vorgegebenen Schwellwert erreicht oder überschreitet. Dieser Schwellwert kann insbesondere niedriger liegen als die maximale Blockierspannung des Steuerelements. Beispielsweise kann der Schwellwert zwischen 70 % und 95 %, bevorzugt zwischen 75 % und 90 %, der maximalen Blockierspannung des Steuerelements liegen. Sollte eine abnorm hohe Spannung U₁ über dem Steuerelement abfallen, kann auf diese Weise sichergestellt werden, dass Gegenmaßnahmen rechtzeitig greifen und die maximale Blockierspannung, bzw. die Zerstörschwelle, des Steuerelements nicht erreicht wird.

In einer weiteren besonders vorteilhaften Ausgestaltung der Erfindung ist die Rückkopplung als Regelschleife für die über dem Steuerelement abfallende Spannung U₁ ausgebildet, wobei der Sollwert dieser Regelschleife durch das eingangsseitige Steuersignal veränderbar ist. Die Rückkopplung greift dann nicht in eine bestehende Bildung einer Stellgröße aus dem Steuersignal ein. Stattdessen sind die Bildung der Stellgröße und die Berücksichtigung der Rückkopplung in einem Prozess, bzw. in einer Schaltung, vereint. Wenn das Steuermodul beispielsweise als Schalter für Hochspannung fungiert, kann zum Schließen (= Einschalten) des Schalters der Sollwert für die über dem Steuerelement abfallende Spannung U₁ auf oder nahe Null gesetzt werden. Es wird dann eine solche Stellgröße ausgegeben, die das Steuerelement durchgängig schaltet. Zum Öffnen (= Ausschalten) des Schalters kann der Sollwert auf die für das Steuerelement vorgesehene zulässige Blockierspannung gesetzt werden. Es wird dann eine solche Stellgröße ausgegeben, die das Steuerelement sehr hochohmig schaltet.

Der Arbeitspunkt des Steuerelements ist in einer weiteren vorteilhaften Ausgestaltung der Erfindung so dimensioniert, dass das Steuerelement zeitabschnittsweise im Linearbetrieb arbeitet und/oder durch die Rückkopplung in den Linearbetrieb überführbar ist. Die Rückkopplung kann dann insbesondere die Wirkung einer Proportionalregelung haben.

Wenn das Steuermodul seine Versorgungsspannung Vcc aus der über dem Steuerelement abfallenden Spannung U₁ bezieht, hat dies zur Folge, dass sich insbesondere eine als Hochspannungsschalter ausgebildete Steuerschaltung aus einer Reihenschaltung vieler Steuermodule wesentlich einfacher, kostengünstiger und kompakter herstellen lässt.

Bei den meisten herkömmlichen Hochspannungsschaltern wurden alle Steuermodule in der Reihenschaltung zentral mit Energie versorgt. Da sich jedes Steuermodul auf einem anderen Potential befindet, musste die Versorgungsspannung Vcc für jedes Steuermodul transformatorisch auf das jeweilige Potential angehoben werden. Das höchste dieser Potentiale entsprach dem Betrag der zu schaltenden Hochspannung U₀ abzüglich der Blockierspannung eines einzelnen Steuerelements. Die notwendige Isolationsstrecke für diese Potentialdifferenz war bislang der begrenzende Faktor für die Skalierbarkeit elektronischer Hochspannungsschalter. Bei der erfindungsgemäßen dezentralen Versorgung der einzelnen Steuermodule aus der jeweils über dem Steuerelement abfallenden Spannung ist die über einem solchen Steuermodul abfallende Spannung U₁ die höchste auftretende Potentialdifferenz. Diese Potentialdifferenz, und damit auch die notwendige Isolationsstrecke, sind prinzipiell unabhängig von der Anzahl der in Reihe geschalteten Steuermodule. Durch die dezentrale Versorgung der Steuermodule wird ein aus solchen Modulen zusammengesetzter Hochspannungsschalter also beliebig skalierbar. Insbesondere ist der Hochspannungsschalter auch nachträglich erweiterbar. Dies betrifft sowohl ein Aufrüsten auf höhere Spannungen als auch ein Aufrüsten auf eine höhere Stromtragfähigkeit durch eine Parallelschaltung einer zweiten identischen Reihe aus Steuermodulen. In den meisten Anwendungen machte es die zentrale Energieversorgung für alle Steuermodule erforderlich, bereits bei der Entwicklung, spätestens aber beim Bau des Hochspannungsschalters die maximal zulässige Spannung U₀ und auch den maximal zulässigen Strom festzulegen.

Zur nachträglichen Skalierbarkeit und Erweiterbarkeit trägt insbesondere auch bei, dass der Eingang für das Steuersignal ein optischer Eingang ist, der über eine direkte Sichtverbindung, und/oder über mindestens einen spekularen oder diffusen Reflektor, von einem Sender beleuchtbar ist. Der Sender kann insbesondere ein zentraler Sender sein, der mehrere oder alle Steuermodule in einer Steuerschaltung gleichzeitig beleuchtet. Optisch angesteuerte Steuermodule nach dem bisherigen Stand der Technik waren über eine faseroptische Leitung mit einer zentralen Steuereinheit verbunden. Die Verwendung eines optischen Ansteuersignals an Stelle eines elektrischen Ansteuersignals war also eine reine Potentialtrennung durch die isolierende optische Faser, die eine transformatorische Überwindung der Potentialbarriere ersetzte. Analog zur elektrischen Verkabelung für die Energieversorgung der Steuermodule brachte es aber auch die faseroptische Verkabelung für die Ansteuerung mit sich, dass die Anzahl der Steuermodule in einer Steuerschaltung spätestens beim Bau der Steuerschaltung festgelegt werden musste und im Nachhinein nicht mehr erweiterbar war.

Das Steuerelement eines einzelnen Steuermoduls weist vorteilhaft eine maximale Blockierspannung zwischen 600 V und 1000 V, bevorzugt zwischen 700 V und 900 V, auf. In diesem Bereich liegt ein optimaler Kompromiss bezüglich des Preises eines einzelnen Steuerelements einerseits und der für technische Anwendungen erforderlichen Anzahl an Steuermodulen andererseits.

Die Steuerschaltung umfasst vorteilhaft zwischen 50 und 100, bevorzugt zwischen 70 und 90, in Reihe geschaltete Steuermodule. Je mehr Steuermodule in Reihe geschaltet sind, desto höhere Spannungen können letztendlich geschaltet werden. Andererseits wird es mit steigender Zahl der Steuermodule auch anspruchsvoller, sie mit so engen Toleranzen zueinander zu fertigen und zu verbauen, dass sie möglichst alle zur selben Zeit geschaltet werden. Insbesondere sollte die Reihenschaltung keinen "Ausreißer" enthalten, der bei gleichzeitiger Ansteuerung aller Steuermodule deutlich vor oder deutlich nach allen anderen Steuermodulen schaltet. Bei solchen Betriebszuständen könnten einzelne Steuermodule, insbesondere die in ihnen enthaltenen Steuerelemente, mit übermäßig hohen Spannungen U₁ beaufschlagt werden.

Vorteilhaft ist die Summe der maximalen Blockierspannungen aller Steuerelemente um zwischen 10 % und 25 %, bevorzugt um zwischen 15 % und 20 %, höher als die maximale über die Reihenschaltung abfallende Spannung U₀. Auf diese Weise enthält die Steuerschaltung einen gewissen Grad an Redundanz und zugleich ein gewisses Maß an Toleranz gegenüber der Streuung in den Zeitpunkten, zu denen die gleichzeitig angesteuerten Steuermodule tatsächlich schalten.

Vorteilhaft sind mindestens ein Tiefsetzsteller, und/oder mindestens ein regelbarer Vorwiderstand, zur Umwandlung der über dem Steuerelement abfallenden Spannung U₁ in die Versorgungsspannung Vcc des Steuermoduls vorgesehen. Mit diesen Elementen ist es möglich, aus einem besonders großen Eingangsspannungsbereich, beispielsweise zwischen 100 V und 1000 V, eine gleichbleibende Versorgungsspannung Vcc in der Größenordnung 10 V bis 25 V zu erzeugen. Die Erfinder haben in ihren Versuchen besonders gute Erfahrungen mit einer Versorgungsspannung von 22 V gemacht. Der optimale Wert für die Versorgungsspannung hängt in hohem Maße von den Eigenschaften des für die konkrete Anwendung gewählten Steuerelements, beispielsweise eines als Steuerelement eingesetzten Leistungshalbleiters, ab.

Insbesondere kann der regelbare Vorwiderstand gemeinsam mit den auf dem Steuermodul zu versorgenden Schaltungskomponenten, beispielsweise mit der Treiberschaltung und/oder den für die Berücksichtigung der Rückkopplung erforderlichen Komponenten, einen Spannungsteiler bilden. Der nutzbare Eingangsspannungsbereich ist dann besonders groß.

In einer besonders vorteilhaften Ausgestaltung der Erfindung ist der regelbare Vorwiderstand ein Transistor, wobei die Basis dieses Transistors auf einer vorgegebenen Spannung V_{S} stabilisiert ist und/oder wobei ein Strom I_{B} von der Basis dieses Transistors zu einem Massepotential auf einem vorgegebenen Wert Is stabilisiert ist. Dieser Transistor kann insbesondere ein Bipolartransistor sein. Der Transistor kann beispielsweise ein NPN-Transistor sein, dessen Kollektor mit der hohen Seite der über dem Steuermodul abfallenden Potentialdifferenz U₁ verbunden ist und dessen Emitter die Versorgungsspannung Vcc bereitstellt. Diese Versorgungsspannung Vcc ist auf die tiefe Seite der über dem Steuermodul abfallenden Potentialdifferenz U₁ bezogen, wobei diese tiefe Seite zugleich das Massepotential dieses Steuermoduls bildet.

Der NPN-Transistor enthält in seiner Darstellung als Ersatzschaltbild mit Dioden eine erste, in Sperrrichtung gepolte, Diode zwischen Kollektor und Basis sowie eine zweite, in Durchlassrichtung gepolte, Diode zwischen Basis und Emitter. Die über dem NPN-Transistor abfallende Spannung ist im Wesentlichen die Spannung, die über der Diode zwischen Kollektor und Basis abfällt. Die Potentialdifferenz zwischen der Basis des Transistors und dem Massepotential entspricht also im Wesentlichen der Versorgungsspannung V_{CC}. Die Stabilisierung der Basis des Transistors bewirkt also unmittelbar, dass die Leitfähigkeit der Diode zwischen Kollektor und Basis bei Schwankungen der Eingangsspannung U₁ derart nachgeführt wird, dass die Versorgungsspannung Vcc im Wesentlichen konstant bleibt.

Um die Basis des Transistors auf der vorgegebenen Spannung V_{S} zu stabilisieren, kann diese Basis in einer weiteren besonders vorteilhaften Ausgestaltung der Erfindung über mindestens einen weiteren Transistor, dessen Basis mit einer aus der vorgegebenen Spannung V_{S} abgeleiteten Referenzspannung V_{R} vorgespannt ist, und/oder über mindestens eine mit der Differenz zwischen dieser Referenzspannung V_{R} und der vorgegebenen Spannung V_{S} vorgespannte, in Sperrrichtung geschaltete Diode, mit dem Massepotential des Steuermoduls verbunden sein.

Alternativ oder auch in Kombination hierzu kann ein Strom I_{B} von der Basis des Transistors, der als regelbarer Vorwiderstand dient, zum Massepotential durch einen Stromspiegel aus zwei Bipolartransistoren gesteuert sein, wobei der Steuerstrom Is dieses Stromspiegels durch denjenigen Strom gebildet ist, den die vorgegebene Spannung Vs, und/oder eine hieraus abgeleitete Referenzspannung V_{R}, durch einen vorgegebenen Widerstand zum Massepotential treibt.

Vorteilhaft ist ein Spannungsteiler aus einem Widerstandsnetzwerk und einer in Sperrrichtung gepolten Z-Diode zur Erzeugung der vorgegebenen Spannung Vs aus der über dem Steuerelement abfallenden Spannung U₁ vorgesehen. Die Durchbruchsspannung der Z-Diode ist unabhängig von den beiden Potentialen, zwischen denen die Spannung U₁ über dem Steuerelement abfällt. Die Z-Diode liefert also einen Fixpunkt für die vorgegebene Spannung Vs, der in allen Steuermodulen einer Reihenschaltung identisch sein kann. Vorteilhaft ist die Basis des Transistors, der als regelbarer Vorwiderstand dient, dann über ein identisches Widerstandsnetzwerk mit der hohen Seite der über dem Steuerelement abfallenden Potentialdifferenz U₁ verbunden.

Wenn die Basis des Transistors, der als regelbarer Vorwiderstand dient, über einen weiteren vorgespannten Transistor und/oder über einen Stromspiegel mit dem Massepotential verbunden ist, dann ist diese Verbindung vorteilhaft besonders niederohmig realisierbar. Dadurch ist sichergestellt, dass Ladungen, die über parasitäre Pfade die Basis des Transistors erreichen, zeitnah abfließen können. Solche Ladungen können beispielsweise durch Leckströme vom Kollektor durch die in Sperrrichtung gepolte Diode auf die Basis übergehen. Werden die Ladungen nicht abgeführt, könnte der Transistor spontan leitend werden, wodurch die bereitgestellte Versorgungsspannung Vcc zu groß wird. Dadurch könnten die nachgeschalteten Komponenten des Steuermoduls zerstört werden.

Die Spannungsversorgung in der beschriebenen Weise nimmt tendenziell mehr Energie auf, wenn eine besonders hohe Spannung U₁ über dem Steuerelement abfällt. Dies hat den Nebeneffekt, dass sie diesen Spannungsanstieg etwas vermindert.

Vorteilhaft ist die Versorgungsspannung Vcc des Steuermoduls über einen parallelgeschalteten Energiespeicher geführt. Ein solcher Energiespeicher kann insbesondere ein Kondensator sein. In dem Energiespeicher kann beispielsweise während eines Schaltungszustandes, der mit einer hohen über dem Steuerelement abfallenden Spannung U₁ einhergeht, Energie eingelagert werden, mit der später ein Schaltungszustand, der mit einer sehr niedrigen über dem Steuerelement abfallenden Spannung U₁ einhergeht, wieder verlassen werden kann.

Vorteilhaft ist der Eingang des Steuermoduls zur Umwandlung eines optischen Steuersignals in ein elektrisches Signal für die Treiberschaltung ausgebildet. Ein optisches Signal kann ohne galvanischen Kontakt zwischen einer zentralen Steuereinheit und beliebig vielen Steuermodulen auf beliebig vielen unterschiedlichen Potentialen übertragen werden. Hierzu können beispielsweise Glasfasern oder andere Lichtleiter verwendet werden. Das optische Steuersignal kann aber auch als freier Strahl übertragen werden.

Alternativ kann das Steuersignal auch als Funksignal drahtlos übertragen werden. Der Eingang ist dann vorteilhaft ein Funkempfänger. Auch dies kann in einer Weise geschehen, dass der Empfänger keine eigene Stromversorgung benötigt, indem analog zur RFID-Technik auch die für den Empfang des Steuersignals notwendige Energie drahtlos übertragen wird.

In einer besonders vorteilhaften Ausgestaltung der Erfindung ist der Eingang zur Umwandlung des optischen Steuersignals in einen Strom Iᵢₙ ausgebildet. Die Treiberschaltung weist eine erste Verstärkerstufe für diesen Strom sowie eine Endstufe zur Umwandlung des verstärkten Stroms Iv in eine weiter verstärkte Ausgangsspannung als Stellgröße auf. Die Umsetzung in ein Stromsignal ist gegenüber der Umwandlung in ein Spannungssignal viel störunempfindlicher gegenüber magnetischen bzw. elektromagnetischen Störeinkopplungen. Dementsprechend unempfindlicher gegenüber Störungen ist auch die stromgesteuerte Verstärkung des Stroms Iᵢₙ bzw. Iv zur letztendlichen Ausgangsspannung.

Das optische Steuersignal kann beispielsweise durch einen Fotodiode in einen Strom Iᵢₙ umgewandelt werden. Dieser Strom Iᵢₙ ist sehr klein; er liegt typischerweise in der Größenordnung weniger Mikroampere. Wird dieser Strom Iᵢₙ zunächst stromverstärkt, ist das Risiko minimiert, dass das Steuersignal durch äußere Störungen verfälscht wird. Spannungssignale sind für derartige Störungen deutlich anfälliger als Stromsignale. Beispielsweise können zeitabhängige äußere Magnetfelder in einer Vielzahl von Leiterschleifen in einer Schaltung Spannungen induzieren, die kleine Spannungssignale in diesen Leiterschleifen stark verfälschen können. Aus diesen störenden Spannungen werden jedoch nur dann störende Stromsignale, wenn die Spannungen über geeigneten Widerständen abfallen. Es führt also nicht jede in einer Schaltung durch äußere Magnetfelder induzierte Spannung auch zu einem störenden Stromsignal.

Dass die erste Verstärkerstufe stromverstärkend arbeitet, bewirkt in Verbindung mit dem kleinen Eingangsstrom Iᵢₙ, beispielsweise aus einer Fotodiode, weiterhin, dass die Treiberschaltung insgesamt sehr wenig Energie benötigt. Bei einer Versorgungsspannung Vcc um 20 V werden typischerweise weniger als 200 µA Strom benötigt. Dies ist insbesondere in Verbindung mit einer Spannungsversorgung der Treiberschaltung aus der über dem Steuerelement abfallenden Spannung U₁ in der beschriebenen Weise vorteilhaft. Diese Art der Spannungsversorgung hat den Vorteil, dass ein sehr großer Eingangsspannungsbereich zwischen etwa 100 V und etwa 1000 V genutzt werden kann, der also eine ganze Größenordnung umfasst. Dies wird damit erkauft, dass diese Spannungsversorgung nur einen energetischen Wirkungsgrad um die 2,5 % hat. Je geringer also die Verlustleistung der Treiberschaltung ist, desto weniger Wärme wird in deren Spannungsversorgung produziert und muss abgeführt werden.

Die Bereitstellung einer Ausgangsspannung durch die Endstufe ist insbesondere im Zusammenhang mit spannungsgesteuerten Steuerelementen vorteilhaft, wie beispielsweise Transistoren, MOSFETs oder IGBTs, die durch das Aufbringen einer Ladungsmenge auf eine Steuerelektrode (Gate) angesteuert werden. Es ist aber auch bei einem Thyristor vorteilhaft, wenn die Endstufe eine Ausgangsspannung bereitstellt. Ein Thyristor wird durch einen Strom-Zündimpuls eingeschaltet und schaltet erst dann wieder aus, wenn der Laststrom unterhalb des Haltestroms abgesunken ist und der Thyristor sich anschließend erholt hat. Der Ansteuerkreis muss also nur den Zündimpuls sicher bereitstellen. Mit einer Endstufe, die eine Ausgangsspannung bereitstellt, kann die hierfür benötigte Ladungsmenge beispielsweise auf einem Kondensator gespeichert und über eine Z-Diode als Zündimpuls in den Ansteuerkreis des Thyristors geleitet werden. Damit muss auch die Stromversorgung der Treiberschaltung nicht dafür ausgelegt sein, den hohen Strom, der kurzzeitig für den Zündimpuls benötigt wird, liefern zu können.

Vorteilhaft ist hierbei zwischen die erste Verstärkerstufe und die Endstufe ein Diskretisierer für den verstärkten Strom Iv geschaltet. Hinter diesem Diskretisierer nimmt der verstärkte Strom I_{V} dann also nur noch einen von mehreren diskreten Werten an. Insbesondere bei Schaltern interessieren häufig nur zwei Zustände "Ein" oder "Aus". Mit dem Diskretisierer können auch durch äußere Störungen leicht verfälschte Stromsignale noch dem korrekten Zustand "Ein" oder "Aus" zugeordnet werden. Der Einfluss der äußeren Störungen wird dadurch unterdrückt.

In einer besonders vorteilhaften Ausgestaltung der Erfindung weisen in einer Reihenschaltung aus mindestens zwei Steuermodulen alle Steuermodule einen Eingang für ein optisches Steuersignal auf, und es ist ein zentraler Sender zur gleichzeitigen Beaufschlagung aller Eingänge mit dem optischen Steuersignal vorgesehen.

Es ist im Prinzip auch möglich, mehrere Sender vorzusehen, die gleichzeitig angesteuert werden. Mit nur einem zentralen Sender ist es jedoch wesentlich einfacher, an allen Eingängen eine gleichmäßige Lichtintensität vorzulegen. Insbesondere eine als optischer Empfänger verwendete Fotodiode ist primär ein analoger Empfänger, der ein Stromsignal mit einer von der eingestrahlten Lichtintensität abhängigen Stromstärke abgibt. Eine an allen Eingängen gleiche Lichtintensität begünstigt insbesondere bei einem Hochspannungsschalter, dass auf das Signal des zentralen Senders hin alle Steuermodule gleichzeitig schalten.

Hierfür ist es insbesondere vorteilhaft, wenn der zentrale Sender eine Lichtquelle aufweist und wenn er weiterhin einen Reflektor zur zeitgleichen Weiterleitung des von der Lichtquelle emittierten Lichts an eine Mehrzahl der Eingänge aufweist und/oder die Lichtquelle an einem Ort angeordnet ist, von dem aus eine direkte Sichtverbindung zu einer Mehrzahl der Eingänge besteht. Insbesondere vereinfacht es der Reflektor, in einer weiteren besonders vorteilhaften Ausgestaltung der Erfindung die Eingänge auf Orte zu verteilen, an denen sie bei Aktivierung der Lichtquelle mit gleichen Lichtintensitäten beaufschlagt werden. Insbesondere kann der Reflektor zur zeitgleichen Weiterleitung des von der Lichtquelle emittierten Lichts an alle Eingänge ausgebildet sein, oder die Lichtquelle kann an einem Ort angeordnet sein, von dem aus eine direkte Sichtverbindung zu allen Eingängen besteht. Der Reflektor und/oder die direkte Sichtverbindung zu den Eingängen ersetzen jeweils einzeln oder in Kombination die nach dem bisherigen Stand der Technik eingesetzte faseroptische Übertragung eines optischen Steuersignals zu den Eingängen. Diese faseroptische Übertragung war ein Grund dafür, dass die Anzahl der Steuermodule in der Steuerschaltung spätestens bei deren Bau festgelegt werden musste und im Nachhinein nicht mehr erweiterbar war.

Beispielsweise können die Steuermodule, die in der Steuerschaltung in Reihe geschaltet sind, in einem gemeinsamen Gehäuse in einem zweidimensionalen Array in einer Ebene oder auch in einem dreidimensionalen Array angeordnet sein. Unter einem dreidimensionalen Array ist beispielsweise die Innenseite einer Halbkugel oder eines anderen Ellipsoiden zu verstehen. Zur Bereitstellung eines zwei- oder dreidimensionalen Arrays kann das Gehäuse beispielsweise in Fächer unterteilt sein, wobei in jedem Fach ein Steuermodul angeordnet ist. Die Wände der Fächer stellen dann die Isolationsstrecken zwischen den Steuermodulen, die sich auf unterschiedlichen Potentialen befinden, bereit.

Vorteilhaft enthält der Deckel des Gehäuses den Reflektor und die Lichtquelle. Der zentrale Sender ist dann maximal kompakt in die Steuerschaltung integriert, und zugleich sind alle Eingänge von störendem Fremdlicht abgeschirmt.

Das Steuermodul, bzw. die Steuerschaltung, eignet sich sowohl für Gleichstromkreise als auch für Wechselstromkreise, wobei im Falle von Wechselstromkreisen die über dem Steuerelement abfallende Wechselspannung während beider Halbschwingungen die gleiche Polarität aufweisen muss. Die Spannungsankopplung des Steuermoduls kann beispielsweise über einen Brückengleichrichter erfolgen. Ebenso kann die Rückkopplung der über dem Steuerelement abfallenden Spannung U₁ im Steuermodul über einen Brückengleichrichter geführt sein, damit die Rückkopplung nur auf den Betrag dieser Spannung U₁ sensitiv ist.

Ein Hochspannungsschalter als erfindungsgemäße Steuerschaltung eignet sich besonders zur Erzeugung von Hochspannungs-Testimpulsen für die Untersuchung des Alterungszustandes von Energieversorgungskabeln. Gerade in dieser Anwendung ist ein sehr häufiges Schalten erforderlich, was einen mechanischen Schalter schnell verschleißen würde. Daneben eignet sich der Hochspannungsschalter beispielsweise auch für folgende energietechnische Anwendungen:

Der Schalter kann direkt im Bereich der Mittel- und Hochspannungsumrichter eingesetzt werden. Mit ihm ist es beispielsweise im Bereich von zukünftigen Gleichspannungsnetzen möglich, einen Tiefsetzsteller aufzubauen, der die Spannung aus dem DC-Netz eines Energieversorgers, z.B. 10 kV, auf das Niveau des Endverbrauchers herabsetzt z.B. 200-300 V. Eine in AC-Netzen übliche transformatorische Umwandlung wäre hier nur mit einem sehr hohen Aufwand möglich. Hierdurch ergibt sich eine wesentliche Volumen- und Gewichtsersparnis.

Auch zur Gleichspannungserhöhung kann der Schalter eingesetzt werden, um etwa Solaranlagen mit geringem Aufwand an ein Mittelspannungs-DC-Versorgungsnetz anzuschließen. Ferner lässt sich mit ihm ein Einsatz als bidirektionales Schaltelement in einer Koppelstelle zwischen verschiedenen Netzen gleicher Spannungsebene bei vergleichsweise geringem Aufwand realisieren. Dies macht den Schalter nicht nur für Hersteller von Mittel- und Hochspannungsumrichtern, sondern auch für Energieversorger interessant.

Eine Crowbar ist ein schaltender Zweipol, der dazu verwendet wird, um in einem Umrichtersystem im Fehlerfall noch gespeicherte Energie definiert abzuführen. In diesem Fall wird ein Widerstand durch das Schließen eines Schalters parallel zu einem Energiespeicher (z.B. Kondensator) geschaltet, so dass die noch vorhandene elektrische Energie in thermische umgewandelt wird. Die eingesetzten Schaltelemente bestehen in vielen Fällen aus einer Reihenschaltung von Thyristoren. Sind diese eingeschaltet, so können sie nicht durch das Zurücknehmen des Ansteuerimpulses wieder abgeschaltet werden. Erst am Ende der Entladung, wenn der Strom nahezu null Ampere beträgt, beginnt der Schalter zu blockieren.

Andere Hersteller bieten z.T. Lösungen auf Basis von leistungsstarken IGBTs an. Da IGBTs verglichen mit Thyristoren bezogen auf ihre Baugröße aber eine wesentlich geringe Stromtragfähigkeit besitzen, wird der Aufbau deutlich größer. Darüber hinaus ist auch die zur Ansteuerung des eigentlichen Lastschalters notwendige Schaltungstechnik, verglichen mit der Ansteuerung eines Thyristors, deutlich komplexer. Ein Vorteil des IGBTs gegenüber dem Thyristor ist jedoch die Möglichkeit, den Stromfluss wieder unterbrechen zu können. So wäre es mit einem Schalter auf Basis von IGBTs zum Beispiel möglich, die noch vorhandene Energie nicht vollkommen in Wärme umzuwandeln, sondern nur soweit abzusenken, dass eine weitere Gefährdung verhindert wird.

Der erfindungsgemäße Schalter ist durch die Verwendung von Standard-Leistungshalbleitern sehr gut skalierbar, was geringere Abmessungen ermöglicht und den Nachteil eines großen Bauvolumens bestehender Lösungen vermeidet. Durch den Einsatz von IGBTs ist es darüber hinaus möglich, den Schalter bei Unterschreiten einer Gefährdungsschwelle wieder abzuschalten, was mit den Thyristorlösungen nicht möglich ist. Eigene Untersuchungen haben zudem gezeigt, dass sich die verwendeten IGBTs vorübergehend wesentlich stärker überlasten lassen, als es zunächst angenommen worden war. Mit diesen Erkenntnissen lassen sich Crowbars realisieren, die deutlich weniger Bauvolumen beanspruchen als es bei derzeit üblichen Lösungen der Fall ist, da weniger Leistungshalbleiter eingesetzt werden müssen.

Der erfindungsgemäße Schalter zeichnet sich, verglichen mit derzeit kommerziell erhältlichen Schaltern, durch folgende Vorteile aus:
- Der Schalter ist in seinem Aufbau, d.h. in Bezug auf die Blockierspannungsfestigkeit in beliebiger Höhe und zu einem beliebigen Zeitpunkt erweiterbar. Bei derzeit verfügbaren Schaltern muss bereits zum Entwicklungs- oder zumindest Fertigungszeitpunkt die maximal im System auftretende Spannung festgelegt werden. Die von uns entwickelte Lösung ließe sich auch noch während des Betriebes durch das Hinzufügen weiterer Schalterstufen erweitern, wenn diese Option beim Gehäusedesign bereits berücksichtigt wurde.
- Der Schalter wurde so entwickelt, dass er aus günstigen, leicht verfügbaren Einzelkomponenten besteht, die von vielen Herstellern angeboten werden. Dies steht im Gegensatz zur aktuellen Realisierung, die auf speziellen Hochleistungshalbleitern eines Herstellers basiert und an deren Verfügbarkeit und Preisgestaltung gebunden ist.
- Einige Hochspannungsschalter benötigen zur Ansteuerung lediglich einen Lichtimpuls, der über eine Faser direkt in den Halbleiter eingekoppelt wird. Durch die galvanische Trennung von Ansteuerung und Leistungskreis, die von der Faser sichergestellt wird, reduzieren sich die Herausforderungen während der Entwicklung. Gleichzeitig muss jedoch auch berücksichtigt werden, dass es nur sehr wenige oder gar nur einen Hersteller für Schalter dieser Art gibt und somit eine starke vertragliche Bindung zu diesem besteht. Die von uns verwendete Schaltungstechnik auf Basis einer optischen Übertragung verwendet, wie schon oben in Bezug auf die Leistungselektronik und die Ansteuerungsschaltung erwähnt, nur Standardkomponenten, die sich verhältnismäßig einfach gegen ähnliche Bauteile anderer Hersteller austauschen lassen.

- Derzeit verfügbare Hochspannungsschalter sind in Bezug auf ihre Schaltfrequenz durch die zum Einsatz kommenden, verhältnismäßig langsam schaltenden Hochspannungsschalter stark eingeschränkt. Da bei unserem System Leistungsbauteile aus einem deutlich niedrigeren Spannungsbereich eingesetzt werden, die bereits generell für höhere Schaltfrequenzen entwickelt wurden, ist auch generell eine deutlich höhere Schaltfrequenz des gesamten Schalters möglich.
- Es besteht eine freie Wahl zwischen spannungsgesteuerten und stromgesteuerten Steuerelementen. Ein spannungsgesteuertes Steuerelement hat beispielsweise gegenüber einem Thyristor den Vorteil, dass sich der Stromfluss in einem Wechselstromkreis nicht nur im Moment des Nulldurchgangs des Stroms unterbrechen lässt.

### Spezieller Beschreibungsteil

Nachstehend wird der Gegenstand der Erfindung an Hand von Figuren erläutert, ohne dass der Gegenstand der Erfindung hierdurch beschränkt wird. Es ist gezeigt:
Figur 1: Zentrale (Figur 1a) und dezentrale (Figur 1b) Energieversorgung und Ansteuerung der Steuermodule 1 in einer Steuerschaltung 100 für Hochspannung.
Figur 2: Schaltung 103 zur Bildung der Versorgungsspannung Vcc des Steuermoduls 1 aus der über dem Steuerelement 4 abfallenden Spannung U₁.
Figur 3: Rückkopplung 7a-7h der über dem Steuerelement 4 abfallenden Spannung U₁ in die Treiberschaltung 6.
Figur 4: Ausbildung der Rückkopplung 7 der über dem Steuerelement 1 abfallenden Spannung U₁ als Regelschleife 22.
Figur 5: Aufteilung des Steuermoduls 1 in eine erste Platine 61 mit der Treiberschaltung 6 und eine über Steckverbinder 42 hiermit verbundene Platine 42 mit Steuerelementen 4.
Figur 6: Anordnung der Treiberschaltungen 6, 61 mehrerer Steuermodule 1 in einem zweidimensionalen Array 63, 64 innerhalb eines Gehäuses 62 (Figur 6a). Deckel 65 des Gehäuses 62 mit integriertem zentralem Sender 30.

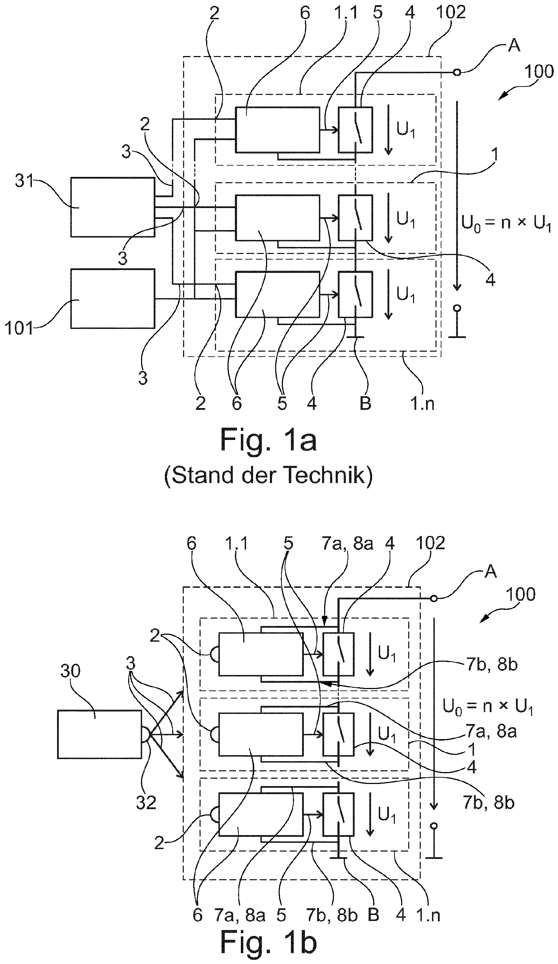

Figur 1a zeigt eine Steuerschaltung 100 nach dem bisherigen Stand der Technik, die als Schalter für eine Hochspannung U₀ ausgebildet ist. Die Steuerschaltung 100 umfasst eine Reihenschaltung 102 von n Steuermodulen 1.1 bis 1.n im durch die Hochspannung U₀ getriebenen Stromkreis A-B. Jedes dieser Steuermodule 1.1 bis 1.n enthält jeweils einen IGBT als Steuerelement 4, der über eine Treiberschaltung 6 mit einer Gatespannung als Stellgröße 5 angesteuert wird. Ist der Schalter ausgeschaltet, stellt jedes der Steuerelemente 4 eine Unterbrechung in dem Stromkreis A-B dar, und die Hochspannung U₀ teilt sich zu gleichen Teilen U₁=U₀/n auf alle Steuerelemente 4 auf. Diese Spannung U₁ liegt in der Größenordnung der Blockierspannung der Steuerelemente 4. Ist der Schalter eingeschaltet, stellt jedes der Steuerelemente 4 einen Durchgang in dem Stromkreis A-B dar, und es fällt über jedem dieser Steuerelemente 4 nur eine sehr geringe Spannung der Größenordnung einiger Volt ab. Dabei ist der genaue Spannungsabfall über dem Steuerelement 4 vom Laststrom durch das Steuerelement 4 abhängig.

Jedes Steuermodul 1.1 bis 1.n erhält eine Versorgungsspannung von einer zentralen Spannungsversorgung 101, die über einen (in Figur 1a nicht eingezeichneten) Transformator auf das Bezugspotential des jeweiligen Steuermoduls 1.1 bis 1.n gebracht wird. Weiterhin erhält jedes Steuermodul 1.1 bis 1.n auch von einer zentralen Steuerung 31 ein Steuersignal 3, das jeweils einem Eingang 2 zugeführt ist. Dies geschieht über separate optische Leitungen zwischen jedem der Steuermodule 1.1 bis 1.n und der zentralen Steuerung 31.

Figur 1b zeigt eine Steuerschaltung 100, in der gegenüber Figur 1a mehrere durch die Erfindung bereitgestellte Neuerungen umgesetzt sind. Jedes Steuermodul 1.1 bis 1.n bezieht auf dem Weg 8a, 8b seine Spannungsversorgung nun aus der über dem jeweiligen Steuerelement 4 abfallenden Spannung U₁. Zugleich ist auf dem Weg 7a, 7b die Spannung U₁ innerhalb des jeweiligen Steuermoduls 1.1 bis 1.n zurückgekoppelt, so dass sich jedes Steuermodul 1.1 bis 1.n autark daraufhin überwacht, dass die am jeweiligen Steuerelement 4 abfallende Spannung im zulässigen Bereich liegt.

Weiterhin sind auch die Eingänge 2 der Steuermodule 1.1 bis 1.n nicht mehr über optische Leitungen mit einer zentralen Steuerung 31 verbunden. Stattdessen ist ein zentraler Sender 30 vorgesehen, der das Steuersignal 3 zeitgleich als freien Strahl an alle Eingänge 2 übermittelt.

Jedes Steuermodul 1.1 bis 1.n ist also sowohl in Bezug auf seine Spannungsversorgung als auch in Bezug auf den Empfang des Steuersignals 3 autark. Daher muss die Anzahl der in Reihe, oder auch parallel, geschalteten Steuermodule 1.1 bis 1.n nicht vorab endgültig festgelegt werden. Stattdessen ist die Steuerschaltung 100 auch im Nachhinein beliebig erweiterbar.

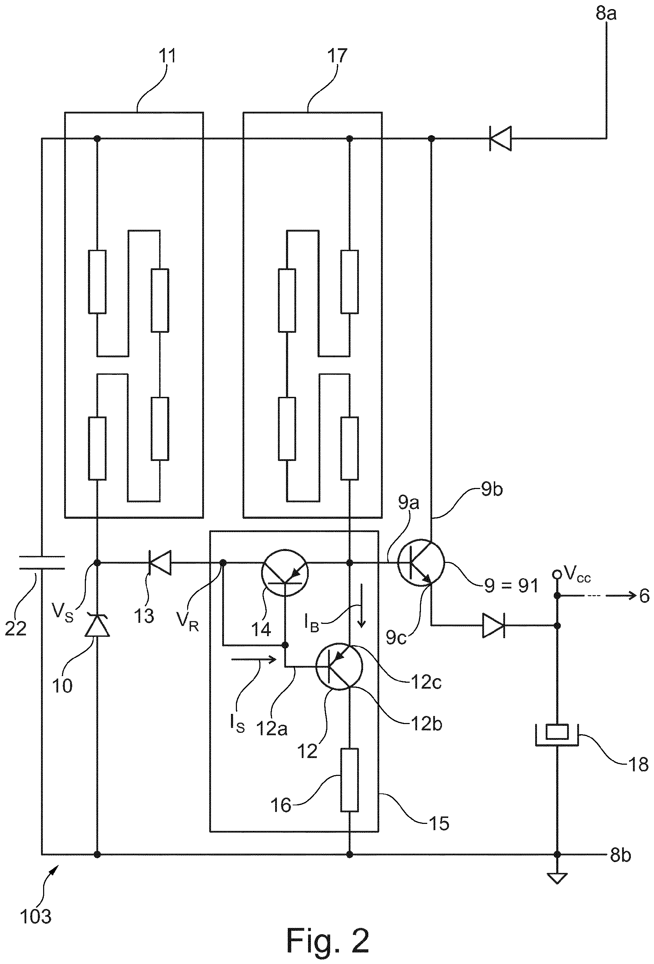

Figur 2 zeigt ein Ausführungsbeispiel einer Schaltung 103, die im Steuermodul 1 aus der über dem Steuerelement 4 abfallenden Spannung U₁ die Versorgungsspannung Vcc für das Steuermodul 1 bildet. Die Spannung U₁ fällt zwischen den Abgriffen 8a und 8b über dem Steuerelement 4 ab, das, ebenso wie die zugehörige Treiberschaltung 6, aus Gründen der Übersichtlichkeit in Figur 2 nicht eingezeichnet ist. Der Abgriff 8a ist in diesem Anwendungsfall über eine Diode vom Typ BY448 geführt.

Die Versorgungsspannung Vcc wird von einem NPN-Bipolartransistor 9 vom Typ BU508AF generiert, der als regelbarer Vorwiderstand 91 für die Treiberschaltung 6 fungiert. Dieser regelbare Vorwiderstand wird im Wesentlichen durch die in Sperrrichtung gepolte Diode zwischen dem Kollektor 9b und der Basis 9a des Transistors 9 bereitgestellt.

Ein Widerstandsnetzwerk 11, bestehend aus vier Widerständen mit einem Widerstandswert von je 412 kΩ, bildet gemeinsam mit einer Z-Diode 10 vom Typ BZX79B20 einen Spannungsteiler, der eine vorgegebene Spannung V_{S} erzeugt. Die Spannung an der Basis 9a des Transistors 9 ist auf diese vorgegebene Spannung V_{S} stabilisiert. Einer Tendenz zu einer Änderung der Spannung an der Basis 9a des Transistors 9 wird dadurch entgegengewirkt, dass diese Änderung sich über die in Durchlassrichtung betriebene Diode zwischen Emitter 12c und Kollektor 12b auch auf die Basis 12a des Transistors 12 auswirkt und dessen Leitfähigkeit entsprechend angepasst wird. Die Basis 12a des Transistors 12 ist mit einer Spannung V_{R} vorgespannt, die durch den Transistor 14 aus der Spannung V_{S} erzeugt wird. Wenn die Spannung an der Basis 9a des Transistors 9 um 0,7 V über das Niveau von Vs ansteigt, bricht zudem die Diode 13 vom Typ 1N4007 durch, und es wird ein zusätzlicher Ableitpfad für einen Strom von der Basis 9a des Transistors 9 eröffnet.

Zugleich erzeugt die vorgegebene Spannung V_{S} auch einen Strom Is, der über den aus den PNP-Bipolartransistoren 12 und 14 vom Typ BC857 bestehenden Stromspiegel 15 den von der Basis 9a des Transistors 9 über den vorgegebenen Widerstand 16 mit einem Widerstandswert von 10 kΩ zum Massepotential 8b fließenden Strom I_{B} auf die Stromstärke von Is stabilisiert. Da die Basis 9a des Transistors 9 mit einem zum Widerstandsnetzwerk 11 identischen Widerstandsnetzwerk 17 beschaltet ist, bewirkt diese Stromstabilisierung wiederum, dass auch der Strom zwischen Kollektor 9b und Emitter 9c des Transistors 9 auf einem konstanten Wert gehalten wird. Dieser Strom erzeugt über der versorgten Treiberschaltung 6 genau denjenigen Spannungsabfall, der der Versorgungsspannung Vcc für die Treiberschaltung entspricht.

Die Transistoren 12 und 14 werden leitend, wenn die Spannung an der Basis 9a des Transistors 9 um ca. 0,7 V höher ist als die vorgegebene Spannung Vs. Dieser Zustand ist erreicht, wenn die Versorgungsspannung Vcc ihren Sollwert erreicht hat. Solange dies nicht der Fall ist, ist es optimal, wenn von der Basis 9a des Transistors 9 kein Strom auf einem anderen Weg abfließt. Dann kann die Versorgungsspannung Vcc zur Ausregelung einer Abweichung schnellstmöglich angehoben werden. Da die Diode zwischen Basis 9a und Emitter 9c des Transistors 9 in Durchlassrichtung gepolt ist, fließen auch parasitäre Ladungen, die beispielsweise durch Leckströme vom Kollektor 9b auf die Basis 9a des Transistors 9 gelangen, beständig ab. Diese Ladungen können sich also nicht auf der Basis 9a sammeln und dazu führen, dass der Transistor 9 zu leitend wird und einen zu hohen Strom in die Treiberschaltung 6 einsteuert.

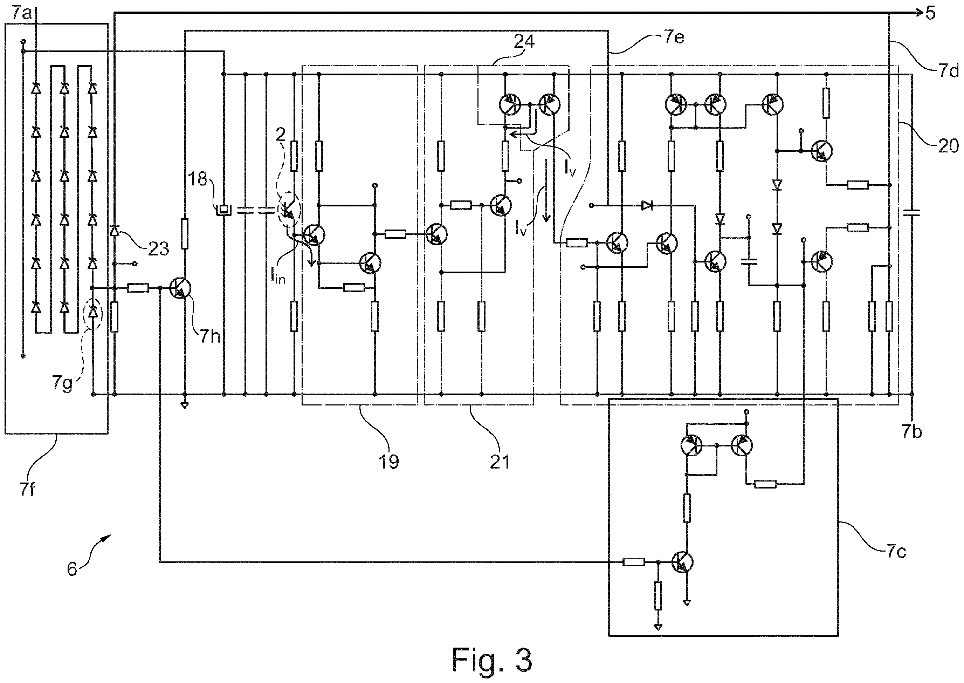

Die Stabilisierung der Versorgungsspannung Vcc unabhängig von der Eingangsspannung U₁ mit Hilfe der Z-Diode 10 als Spannungsnormal lässt sich also sowohl in dem Bild verstehen, in dem die Transistoren 9, 12 und 14 spannungsgesteuert sind, als auch in dem Bild, in dem diese Transistoren 9, 12 und 14 stromgesteuert sind. Die Betrachtung der Transistoren 9, 12 und 14 jeweils als stromgesteuerte Stromverstärker ist einheitlicher damit, dass die Treiberschaltung 6 in dem in Figur 3 gezeigten Ausführungsbeispiel ebenfalls als Stromverstärker aufgebaut ist.

Die Versorgungsspannung Vcc ist über eine weitere Diode vom Typ 1N4007 auf den parallelgeschalteten Kondensator 18 mit einer Kapazität von 330 µF geführt, der als Energiespeicher wirkt. Der Kondensator 22 mit einer Kapazität von 10 nF am linken Rand von Figur 2 ist zum Einen ein Teil der Eingangsspannungspufferung, um transiente Spannungen am Eingang der Versorgungsschaltung 103 zu verringern. Zugleich wirkt dieser Kondensator 22 auch dämpfend auf die Anstiegsgeschwindigkeit der Spannung U₁ über dem Steuerelement 4. Damit wird die Treiberschaltung 6 bereits zu einem kleinen Teil von der Aufgabe entlastet, einen solchen Spannungsanstieg auszuregeln.

Figur 3 zeigt eine Treiberschaltung 6 eines Steuermoduls 1, die um eine Rückkopplung 7a-7h der über dem Steuerelement 4 abfallenden Spannung U₁ erweitert ist. Die Treiberschaltung 6 bezieht ihre Versorgungsspannung aus dem über die Versorgungsschaltung 103 aufgeladenen Kondensator 18, dem zwecks Glättung noch zwei weitere Kondensatoren mit Kapazitäten von jeweils 100 nF parallel geschaltet sind. Die Treiberschaltung 6 hat eine Fotodiode vom Typ S472P / SFH 205 FA als Eingang 2 für das optische Steuersignal 3. Diese Fotodiode befindet sich in der Mitte eines aus zwei Widerständen mit Widerstandswerten von 100 kΩ bzw. 1 MΩ bestehenden Spannungsteilers zwischen der Versorgungsspannung Vcc und dem Massepotential des Steuermoduls 1. Die Fotodiode wandelt das Steuersignal 3 in einen Eingangsstrom Iᵢₙ um. Dieser Eingangsstrom Iᵢₙ wird in einer ersten stromverstärkenden Darlington-Verstärkerstufe 19 mit zwei Bipolartransistoren vom Typ BC847 zunächst verstärkt. Er durchläuft anschließend einen als Schmitt-Trigger ausgebildeten Diskretisierer 21 mit zwei NPN-Bipolartransistoren vom Typ BC847. Der Strom Iv, der aus dem Diskretisierer Iv austritt, nimmt nur noch einen von zwei möglichen Werten an. Einer dieser Werte entspricht der Anweisung, das Steuermodul 1 im Stromkreis A-B für die Hochspannung U₀ zu einer Unterbrechung zu machen, und der andere dieser Werte entspricht umgekehrt der Anweisung, das Steuermodul 1 in diesem Stromkreis A-B zu einem Durchgang zu machen. Der Strom Iv wird über einen Stromspiegel 24 mit zwei PNP-Bipolartransistoren vom Typ BC857 einer Endstufe 20 zugeführt, die eine verstärkte Gatespannung als Stellgröße 5 ausgibt. Diese Gatespannung wird dem Gate des, in Figur 3 nicht eingezeichneten, Steuerelements 4 zugeleitet. Rechts neben der Endstufe 20 ist ein weiterer Glättungskondensator mit einer Kapazität von 100 nF für die Versorgungsspannung der Treiberschaltung 6 angeordnet. Innerhalb der Endstufe 20 sind alle NPN-Bipolartransistoren vom Typ BC847, alle PNP-Bipolartransistoren vom Typ BC857 und alle Dioden vom Typ 1N4148W. Der Kondensator innerhalb der Endstufe 20 hat eine Kapazität von 10 nF.

Die Spannung U₁ fällt zwischen den Abgriffen 7a und 7b ab. Ein Netzwerk 7f aus in Reihe geschalteten Z-Dioden vergleicht die Spannung U₁ mit einem vorgegebenem Wert, ab dem die Rückkopplung aktiv wird. Ist dieser vorgegebene Wert überschritten, bricht auch die letzte Z-Diode 7g in diesem Netzwerk 7f durch, so dass durch sie ein Strom fließt und über ihr eine Spannung abfällt. Alle Dioden in dem Netzwerk 7f mit Ausnahme der Diode 7g sind vom Typ BZX79875. Die Diode 7g ist vom Typ BZX79820.

Die über der Diode 7g abfallende Spannung greift nun an mehreren Stellen in die Treiberschaltung 6 ein. Zunächst einmal wird sie über die Diode 23 vom Typ 1N4148 unmittelbar additiv der Stellgröße 5 zugeschlagen. Der IGBT als Steuerelement 4 ist so aufgebaut, dass er um so leitfähiger ist, je höher die Gatespannung ist. Eine Erhöhung der Stellgröße 5 bewirkt also, dass das Steuerelement 4 leitfähiger wird, so dass wiederum die über ihm abfallende Spannung U₁ abnimmt.

Zugleich wird über die Zusatzschaltung 7c der Ausgang der Endstufe 20, und damit der Treiberschaltung 6, gegen Masse hochohmig geschaltet. Dadurch wird die zusätzlich auf das Gate des Steuerelements 4 aufgebrachte Ladung dort eingeschlossen, so dass kein ständiger zusätzlicher Strom erforderlich ist, um die erhöhte Stellgröße 5 am Gate dauerhaft zu halten. Die Rückkopplung 7a-7h muss also nicht gegen die eigentliche Treiberschaltung 6 ankämpfen. Nach dem Stand der Technik gilt ein solcher Zustand bei Treiberschaltungen 6 für das Gate eines Steuerelements 4 als unerwünscht, da dann störende Einkopplungen von Spannungen, leicht das Verhalten des Steuerelements 4 definieren können. Beispielsweise kann das Potential an einem isolierten Gate eines Leistungshalbleiters durch kapazitive Einkopplung der über dem Leistungshalbleiter abfallenden und sich zeitlich ändernden Blockierspannung beeinflusst werden. In der Zusatzschaltung 7c ist der NPN-Bipolartransistor vom Typ BC847 und die beiden PNP-Bipolartransistoren sind vom Typ BC857.

Um in der Treiberschaltung 6 einen definierten Zustand herzustellen, wird weiterhin durch die über der letzten Z-Diode 7g abfallende Spannung der Transistor 7h vom Typ BC847 leitend geschaltet. Dadurch wird der Punkt in der Endstufe 20, an dem der aus dem optischen Steuersignal 3 erzeugte Strom Iᵢₙ eigentlich erstmals verstärkt werden sollte, mit Masse verbunden und die Endstufe 20 somit wirkungslos geschaltet. Das Steuersignal 3 wird somit in dem Sinne unterdrückt, dass die Treiberschaltung 6 hierauf nicht mehr reagiert.

Die Beschaltungswiderstände des Transistors 7h sowie der Transistoren in den Verstärkerstufen 19 und 20, im Schmitt-Trigger 21 und in der Zusatzschaltung 7c bestimmen die jeweiligen Verstärkungsfaktoren bzw. die diskreten Werte für den Strom Iv ausgangsseitig des Schmitt-Triggers 21. Die Werte dieser Beschaltungswiderstände sind für die jeweilige Anwendung und insbesondere für das konkret ausgewählte Steuerelement 4 spezifisch und werden daher aus Gründen der Übersichtlichkeit hier nicht mit angegeben.

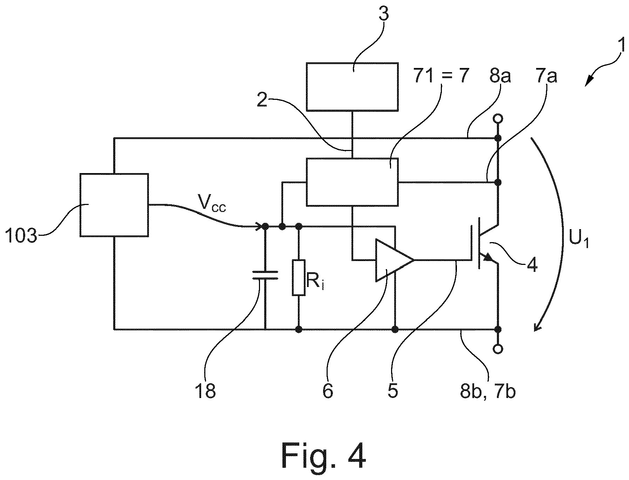

Figur 4 zeigt eine alternative Ausführungsform des Steuermoduls 1. Im Unterschied zur in Figur 3 gezeigten Treiberschaltung 6 sind die Rückkopplung 7 und die Ansteuerung der Treiberschaltung 6 hier in einer Regelschleife 71 vereint. Diese Regelschleife 71 erhält über den Abgriff 7a die Spannung U₁, die über dem Steuerelement 4 abfällt, und regelt diese Spannung U₁ abhängig vom Ansteuersignal 3 auf einen von zwei Sollwerten: Wenn gemäß Ansteuersignal 3 durch das Steuermodul 1 eine Unterbrechung im durch die Hochspannung U₀ getriebenen Stromkreis A-B geschaffen werden soll, entspricht der Sollwert der vorgesehenen Blockierspannung des Steuerelements 4. Wenn gemäß Ansteuersignal 3 hingegen ein Durchgang in dem Stromkreis A-B geschaffen werden soll, ist der Sollwert nahe Null. Die Regelschleife 71 übergibt der Treiberschaltung 6, die hier als einfacher Verstärker ausgebildet ist, einen Stellgrößenwert. Dieser wird vom Verstärker 6 in die Stellgröße 5 für das Gate des Steuerelements 4 umgewandelt. Dabei berücksichtigt die Regelschleife 71 automatisch die harte Randbedingung, dass die Spannung U₁ nicht größer werden darf als die maximale Blockierspannung des Steuerelements 4.

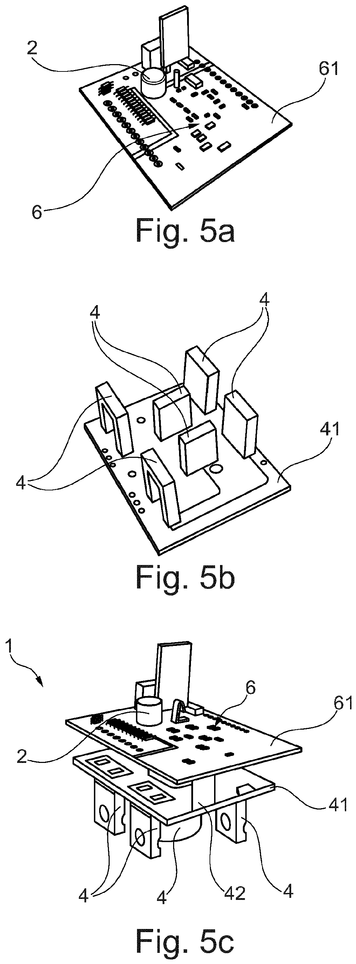

Figur 5 zeigt eine räumliche Aufteilung des Steuermoduls 1, die insbesondere im Hinblick auf eine optische Ansteuerung mit einem zentralen Sender 30 vorteilhaft ist. Die Treiberschaltung 6 mit dem Eingang 2 für das optische Ansteuersignal 3 ist hier auf einer ersten Platine 61 angeordnet. Die Leistungshalbleiter als Steuerelemente 4 sind auf einer zweiten Platine 41 angeordnet. Beide Platinen 61 und 41 sind übereinander angeordnet und über einen Steckverbinder 42 miteinander verbunden. Dabei weisen die bis auf den Steckverbinder 42 unbestückten Seiten der Platinen 61 und 41 aufeinander zu. Der Vorteil dieser dreidimensionalen Anordnung ist, dass das Steuermodul 1 in der Ebene der Platine 61 weniger Platz beansprucht. In einem zweidimensionalen Array in einer Ebene können somit mehr Steuermodule 1 untergebracht und von einem zentralen Sender 30 gleichzeitig optisch angesteuert werden.

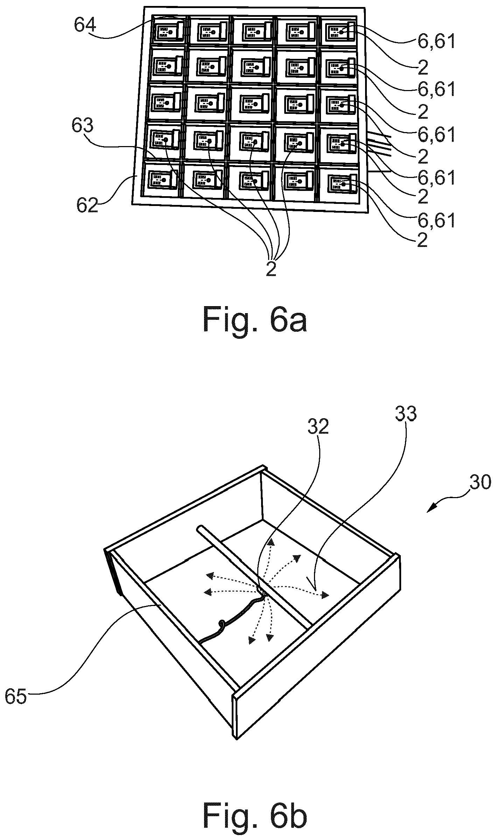

Dies ist in Figur 6a näher dargestellt. Hier ist eine Vielzahl von Steuermodulen 1, von denen aus der in Figur 6a gewählten Perspektive jeweils nur die Treiberschaltungen 6 auf den Platinen 61 sichtbar sind, in einem gemeinsamen Gehäuse 62 angeordnet, das durch regelmäßige Stege 63 und 64 in beiden Dimensionen der Zeichenebene in ein Array von Fächern unterteilt ist. Jedes dieser Fächer beherbergt ein Steuermodul 1.

Zu dem Gehäuse 62 gehört der in Figur 6b näher dargestellte Deckel 65, der auch den zentralen Sender 30 beherbergt. Dieser Sender 30 beinhaltet eine mittig im Deckel 65 montierte Lichtquelle 32. Die Innenwand des Deckels 65 ist als diffuser Reflektor 33 ausgebildet, und die Lichtquelle 32 ist so angeordnet, dass sie nicht direkt auf die optischen Eingänge 2 der Steuermodule 1 strahlt, sondern nur über den diffusen Reflektor 33. Wenn der Deckel 65 auf das Gehäuse 62 aufgesetzt ist und die Lichtquelle 32 aktiviert wird, sorgt der diffuse Reflektor 33 dafür, dass sich im gesamten Gehäuse 62 eine gleichmäßige Beleuchtungsstärke einstellt. Alle optischen Eingänge 2 der Steuermodule 1 liefern dann jeweils gleiche Ströme Iᵢₙ an die Treiberschaltungen 6, so dass idealerweise alle zu den Treiberschaltungen 6 gehörenden Steuerelemente 4 gleichzeitig angesteuert werden und eine Überbeanspruchung einzelner Steuerelemente 4 durch zu hohe abfallende Spannungen U₁ vorteilhaft vermieden wird.

Typische Lichtleistungen, die von einem Eingang 2 eines Steuermoduls 1 aufgenommen werden, liegen zwischen 5 µW und 30 µW.

### Bezugszeichenliste

- 1: Steuermodul
- 2: Eingang des Steuermoduls 1
- 3: Steuersignal
- 4: Steuerelement im Steuermodul 1
- 5: Stellgröße für Steuerelement 4
- 6: Treiberschaltung für Steuerelement 4
- 7, 7a-7h: Rückkopplung der Spannung U₁ im Steuermodul 1
- 7a, 7b: Abgriff der Spannung U₁ für die Rückkopplung
- 7c: Zusatzschaltung zur hochohmigen Schaltung der Endstufe 20
- 7d: Additive Überlagerung der Rückkopplung auf die Stellgröße 5
- 7e: Unterdrückung des Steuersignals 3 in der Treiberschaltung 6
- 7f: Kette von Z-Dioden zur Erkennung zu hoher Spannungen U₁
- 7g: letzte Z-Diode in der Kette 7f
- 7h: Transistor für Unterdrückung 7e
- 8a, 8b: Abgriff der Spannung U₁ zur Versorgung des Steuermoduls 1
- 9: Transistor
- 9a, 9b, 9c: Basis, Kollektor bzw. Emitter des Transistors 9
- 10: Z-Diode zur Festlegung der Spannung Vs
- 11: Widerstandsnetzwerk vor Z-Diode 10
- 12: erster Transistor im Stromspiegel 15
- 13: Diode
- 14: zweiter Transistor im Stromspiegel 15
- 15: Stromspiegel
- 16: Widerstand zwischen Stromspiegel 15 und Massepotential 8b
- 17: Widerstandsnetzwerk vor Basis 9a
- 18: Kondensator als Energiespeicher
- 19: stromverstärkende Verstärkerstufe in Treiberschaltung 6
- 20: Endstufe in Treiberschaltung 6
- 21: Diskretisierer in Treiberschaltung 6
- 22: Kondensator
- 23: Diode
- 24: Stromspiegel in Treiberschaltung 6
- 30: zentraler Sender für Steuersignal 3
- 31: zentrale Steuerung für Steuerelemente 1
- 32: Lichtquelle des Senders 30
- 33: Reflektor des Senders 30
- 41: Platine mit Steuerelementen 4
- 42: Steckverbinder zwischen Platinen 41 und 61
- 61: Platine mit der Treiberschaltung 6
- 62: Gehäuse
- 63, 64: Stege im Gehäuse 62
- 65: Deckel des Gehäuses 62
- 71: Regelschleife
- 91: regelbarer Vorwiderstand
- 100: Steuerschaltung aus Steuerelementen 1
- 101: zentrale Energieversorgung für Steuerelemente 1
- 102: Reihenschaltung der Steuerelemente 1
- 103: Versorgungsschaltung zur Bildung der Spannung Vcc aus U₁
- A-B: von Hochspannung U₀ getriebener Stromkreis
- I_{B}: von Basis 9a abfließender Strom
- Iᵢₙ: aus optischem Ansteuersignal 3 gebildeter Strom
- I_{S}: durch die Spannung V_{S} getriebener Strom
- I_{V}: Strom in Treiberschaltung 6 nach dem Diskretisierer 21
- U₀: gesamte Hochspannung über Steuerschaltung 100
- U₁: über einzelnem Steuerelement 4 abfallende Spannung
- V_{CC}: Versorgungsspannung für Treiberschaltung 6
- V_{S}: vorgegebene Spannung zur Stabilisierung der Basis 9a
- V_{R}: aus der Spannung VS gebildete Referenzspannung

## Patentansprüche

1. Steuermodul (1) zum Modulieren einer Hochspannung U₀, umfassend einen Eingang (2) für ein Steuersignal (3) sowie mindestens ein Steuerelement (4), das im durch die Hochspannung U₀ getriebenen Stromkreis (A-B) einen Widerstand bildet, dessen Betrag als Funktion einer Stellgröße (5) veränderlich ist, weiterhin umfassend eine Treiberschaltung (6) zur Bildung der Stellgröße (5) aus dem eingangsseitigen Steuersignal (3), **dadurch gekennzeichnet, dass** die Treiberschaltung (6) ihre Versorgungsspannung Vcc aus der über dem Steuerelement (4) abfallenden Spannung U₁ bezieht (8a, 8b) und dass der Eingang (2) für das Steuersignal (3) ein optischer Eingang, der über eine direkte Sichtverbindung, und/oder über mindestens einen spekularen oder diffusen Reflektor (33), von einem Sender (30) beleuchtbar ist, oder ein Funkempfänger ist.

2. Steuermodul (1) nach Anspruch 1, **dadurch gekennzeichnet, dass** mindestens ein Tiefsetzsteller, und/oder mindestens ein regelbarer Vorwiderstand (91), zur Umwandlung der über dem Steuerelement (4) abfallenden Spannung U₁ in die Versorgungsspannung Vcc des Steuermoduls (1) vorgesehen sind.

3. Steuermodul (1) nach Anspruch 2, **dadurch gekennzeichnet, dass** der regelbare Vorwiderstand (91) ein Transistor (9) ist, wobei die Basis (9a) dieses Transistors (9) auf einer vorgegebenen Spannung V_{S} stabilisiert ist und/oder wobei ein Strom von der Basis (9a) dieses Transistors (9) zu einem Massepotential (8b) auf einem vorgegebenen Wert stabilisiert ist.

4. Steuermodul (1) nach Anspruch 3, **dadurch gekennzeichnet, dass** die Basis des Transistors (9) über mindestens einen weiteren Transistor (12), dessen Basis (12a) mit einer aus der vorgegebenen Spannung Vs abgeleiteten Referenzspannung V_{R} vorgespannt ist, und/oder über mindestens einer mit der Differenz zwischen dieser Referenzspannung V_{R} und der vorgegebenen Spannung V_{S} vorgespannte, in Sperrrichtung geschaltete Diode (13), mit einem Massepotential (8b) verbunden ist.

5. Steuermodul (1) nach einem der Ansprüche 3 bis 4, **dadurch gekennzeichnet, dass** ein Strom von der Basis (9a) des Transistors (9), der als regelbarer Vorwiderstand (91) dient, zum Massepotential (8b) durch einen Stromspiegel (15) aus zwei Bipolartransistoren (12, 14) gesteuert ist, wobei der Steuerstrom Is dieses Stromspiegels (15) durch denjenigen Strom gebildet ist, den die vorgegebene Spannung Vs, und/oder eine hieraus abgeleitete Referenzspannung V_{R}, durch einen vorgegebenen Widerstand (16) zum Massepotential (8b) treibt.

6. Steuermodul (1) nach einem der Ansprüche 3 bis 5, **dadurch gekennzeichnet, dass** ein Spannungsteiler aus einem Widerstandsnetzwerk (11) und einer in Sperrrichtung gepolten Z-Diode (10) zur Erzeugung der vorgegebenen Spannung V_{S} aus der über dem Steuerelement (4) abfallenden Spannung U₁ vorgesehen ist.

7. Steuermodul (1) nach einem der Ansprüche 1 bis 6, **dadurch gekennzeichnet, dass** die Versorgungsspannung Vcc des Steuermoduls (1) über einen parallelgeschalteten Energiespeicher (18) geführt ist.

8. Steuermodul (1) nach einem der Ansprüche 1 bis 7, **dadurch gekennzeichnet, dass** das Steuerelement (4) ein Halbleiterbauelement ist.

9. Steuermodul (1) nach Anspruch 8, **dadurch gekennzeichnet, dass** das Steuerelement (4) ein Transistor, ein Thyristor, ein MOSFET oder ein IGBT ist.

10. Steuermodul (1) nach einem der Ansprüche 1 bis 9, **dadurch gekennzeichnet, dass** das Steuerelement (4) eine maximale Blockierspannung zwischen 600 V und 1000 V, bevorzugt zwischen 700 V und 900 V, aufweist.

11. Steuerschaltung (100) zum Modulieren einer Hochspannung U₀, **dadurch gekennzeichnet, dass** eine Reihenschaltung (102) aus mindestens zwei Steuermodulen (1) nach einem der Ansprüche 1 bis 10 in den durch die Hochspannung U₀ getriebenen Stromkreis (A-B) geschaltet ist.

12. Steuerschaltung (100) nach Anspruch 11, **dadurch gekennzeichnet, dass** alle Steuermodule (1) einen Eingang (2) für ein optisches Steuersignal (3) aufweisen, wobei ein zentraler Sender (30) zur gleichzeitigen Beaufschlagung aller Eingänge (2) mit dem optischen Steuersignal (3) vorgesehen ist.

13. Steuerschaltung (100) nach Anspruch 12, **dadurch gekennzeichnet, dass** der zentrale Sender (30) eine Lichtquelle (32) aufweist und dass weiterhin der zentrale Sender (30) einen Reflektor (33) zur zeitgleichen Weiterleitung des von der Lichtquelle (32) emittierten Lichts an eine Mehrzahl der Eingänge (2) aufweist und/oder die Lichtquelle (32) an einem Ort angeordnet ist, von dem aus eine direkte Sichtverbindung zu einer Mehrzahl der Eingänge (2) besteht.

14. Steuerschaltung (100) nach einem der Ansprüche 12 bis 13, **dadurch gekennzeichnet, dass** die Eingänge (2) auf Orte verteilt sind, an denen sie bei Aktivierung der Lichtquelle (32) mit gleichen Lichtintensitäten beaufschlagt werden.

15. Steuerschaltung (100) nach einem der Ansprüche 12 bis 14, **dadurch gekennzeichnet, dass** die Steuermodule (1) in einem gemeinsamen Gehäuse (62) in einem zweidimensionalen Array (63, 64) in einer Ebene oder in einem dreidimensionalen Array angeordnet sind.

16. Steuerschaltung (100) nach Anspruch 15, **dadurch gekennzeichnet, dass** der Deckel (65) des Gehäuses (62) den Reflektor (33) und die Lichtquelle (32) enthält.

17. Steuerschaltung (100) nach einem der Ansprüche 1 bis 16, **dadurch gekennzeichnet, dass** die Summe der maximalen Blockierspannungen aller Steuerelemente (1, 1.1-1.n) um zwischen 10 % und 25 %, bevorzugt um zwischen 15 % und 20 %, höher ist als die maximale über die Reihenschaltung (102) abfallende Spannung U₀.

18. Steuerschaltung (100) nach einem der Ansprüche 1 bis 17, **dadurch gekennzeichnet, dass** die Reihenschaltung (102) zwischen 50 und 100, bevorzugt zwischen 70 und 90, Steuermodule (1) umfasst.
